# EUROPÄISCHE PATENTSCHRIFT

(11) **EP 0 822 589 B1**
(45) Veröffentlichungstag und Bekanntmachung des Hinweises auf die Patenterteilung: **22.09.1999**
(21) Anmeldenummer: 97112713.9
(22) Anmeldetag: 24.07.1997
(51) Int. Cl.: H01L 21/68

(54) **Träger zusammen mit einer Halbleiterscheibe und Verfahren zur Behandlung einer Halbleiterscheibe auf einem Träger**
Carrier together with a semiconductor wafer and a method of treating a semiconductor wafer on a carrier
Support ainsi qu'une plaquette semi-conductrice et méthode de traitement d'une plaquette semi-conductrice sur un support

(30) Priorität: 31.07.1996 DE 19630932
(43) Veröffentlichungstag der Anmeldung: 04.02.1998
(73) Patentinhaber: Wacker Siltronic Gesellschaft für Halbleitermaterialien Aktiengesellschaft, 84489 Burghausen (DE)
(72) Erfinder: Sauter, Bernd, Dr., 84547 Emmerting (DE); Seifert, Dieter, Dr., 84524 Neuötting (DE)
(74) Vertreter: Rimböck, Karl-Heinz, Dr.

(56) Entgegenhaltungen:
- EP-A- 0 484 290
- EP-A- 0 665 587
- FR-A- 2 554 250
- US-A- 5 401 692
- VLSI Technology, Second Edition, S. M. Sze, McGraw-Hill Book Company, 1988, Seiten 38-39

## Beschreibung

Die Erfindung betrifft eine Einheit aus einem Träger und einer Halbleiterscheibe und ein Verfahren zur Behandlung einer Halbleiterscheibe auf einem Träger.

Halbleiterscheiben werden in großer Stückzahl hergestellt und zu elektronischen Bauteilen weiterverarbeitet. Der Herstellungsprozeß umfaßt auch Behandlungen der Halbleiterscheiben bei Temperaturen von mindestens 200°C, beispielsweise reine Wärmebehandlungen oder das Abscheiden von Schichten auf der Oberfläche der behandelten Halbleiterscheibe durch thermische Zersetzung von Abscheidegasen. Bei solchen Behandlungen muß streng beachtet werden, daß die Halbleiterscheibe nicht durch unerwünschte Fremdmetalle, Dotierstoffe oder Partikel verunreinigt wird, deren spätere Entfernung nicht oder nur mit erheblichem, zusätzlichem Aufwand möglich ist. Aus US-A-5 401 692 ist eine Methode zur Oxidierung der aktiven Oberfläche einer Halbleiterscheibe bekannt. Um die aktive Oberfläche vor Verunreinigungen zu schützen, wird die Scheibe mit der aktiven Oberfläche nach unten auf einem Träger gelet. Der Träger weist eine Ausnehmung auf, und die Scheibe wird an seinen Kanten von den Seiten der Ausnehmung gestützt.

Es gibt Behandlungsstationen, beispielsweise CVD-Reaktoren, in denen Halbleiterscheiben kontinuierlich bei Temperaturen von mindestens 200°C behandelt werden. Die Halbleiterscheiben werden auf ein Transportband abgelegt und von diesem in die Behandlungsstation transportiert. Relativbewegungen zwischen den Halbleiterscheiben und dem Transportband und der direkte Kontakt der Halbleiterscheiben mit dem Transportband erhöhen das Risiko, daß die Halbleiterscheiben beschädigt und durch Fremdmetalle, die in das Halbleitermaterial diffundieren, verunreinigt werden.

Falls die Halbleiterscheiben beschichtet werden, besteht die Gefahr, daß die aufwachsende Schicht eine feste Verbindung zwischen den Halbleiterscheiben und dem Untergrund herstellt, auf dem die Halbleiterscheiben aufliegen. Es ist dann schwierig, eine anhaftende Halbleiterscheibe vom Untergrund zu lösen, ohne dabei die Halbeiterscheibe zu beschädigen oder zu verunreinigen.

Die Aufgabe der vorliegenden Erfindung bestand darin, die Gefahr der Beschädigung oder der Verunreinigung von Halbleiterscheiben, insbesondere von Halbleiterscheiben aus Silicium, während einer Behandlung der Halbleiterscheiben bei Temperaturen von mindestens 200°C zu reduzieren.

Gegenstand der Erfindung ist eine Einheit aus einem Träger und einer Halbleiterscheibe gemäß Anspruch 1.

Der Träger fixiert die Halbleiterscheibe und verhindert den direkten Kontakt der Halbleiterscheibe mit einem kontaminierenden Untergrund. Die Gefahr, daß die Halbleiterscheibe nach einer Beschichtung am Träger haften bleibt, ist durch die Form des Trägers erheblich reduziert.

Die Erfindung wird nachfolgend an Hand von Figuren näher beschrieben.
Fig.1a zeigt schematisch einen Träger und eine auf dem Träger liegende Halbleiterscheibe gemäß einer Ausführungsform der Erfindung in Schnittdarstellung.
Fig.1b ist eine vergrößerte Teilansicht von Fig.1a.
Fig.2 zeigt den Träger mit Halbleiterscheibe von Fig.1b gemäß einer Weiterbildung der Erfindung.

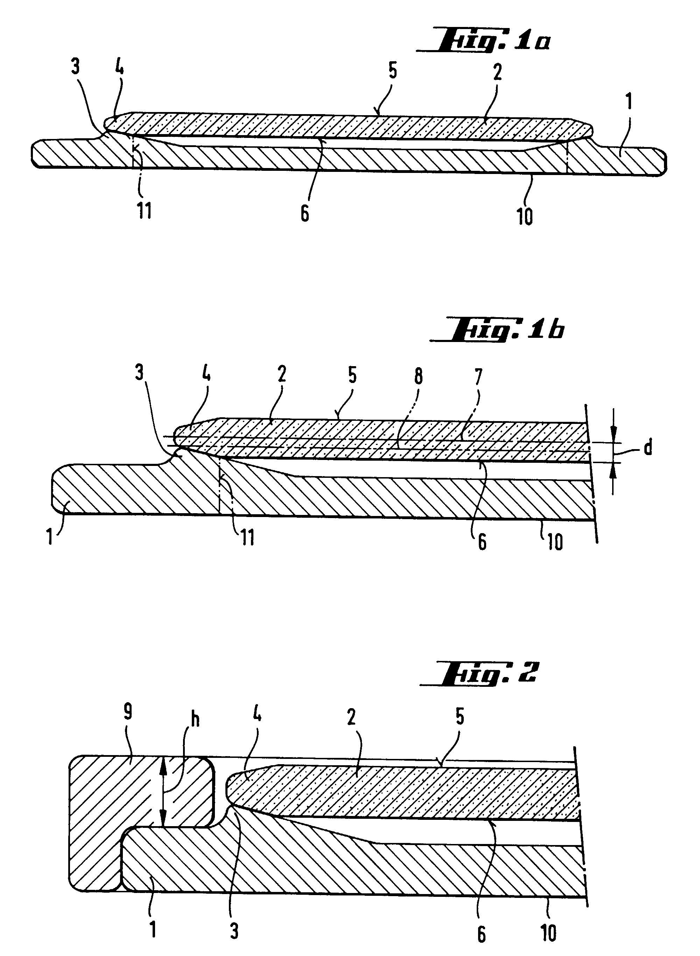

Wie der Fig.1a zu entnehmen ist, ist die Form des Trägers 1 der Form eines Tellers ähnlich. Die Halbleiterscheibe 2 ruht mit ihrer verrundeten Kante 4 auf Erhebungen 3, die am Träger 1 vorgesehen sind. Um die Halbleiterscheibe in einer stabilen Position waagerecht halten zu können, muß der Träger an mindestens drei, voneinander beabstandeten Stellen Erhebungen 3 aufweisen.

Die Halbleiterscheibe besitzt zwei ebene und parallel zueinander liegende Seitenflächen, an die sich eine verrundete Kante anschließt. Im Zusammenhang mit der Erfindung wird diejenige Seitenfläche als Vorderseite der Halbleiterscheibe bezeichnet, die vom Träger weg nach oben weist. Dementsprechend ist die Rückseite der Halbleiterscheibe die gegenüberliegende, nach unten weisende Seitenfläche.

Der Träger 1 berührt weder die Vorderseite 5, noch die Rückseite 6 der Halbleiterscheibe 2. Die Erhebungen 3 sind so geformt, daß sich die Auflagestellen, mit denen die Halbleiterscheibe auf dem Träger aufliegt, ausschließlich auf der Kante der Halbleiterscheibe befinden und zwar unterhalb einer gedachten Mittelebene 7, die in der Mitte zwischen der Vorderseite 5 und der Rückseite 6 der Halbleiterscheibe liegt (Fig.lb). Die Vorderseite 5 der Halbleiterscheibe kann auf diese Weise in einem Reaktor beschichtet werden, ohne daß dabei zu befürchten ist, daß die Beschichtung am Rand der Vorderseite durch die Anwesenheit des Trägers beeinträchtigt wird.

Besonders bevorzugt ist es, die Erhebungen 3 des Trägers so auszubilden, daß die Kante 4 der Halbleiterscheibe ausschließlich unterhalb einer gedachten Ebene 8 abgestützt wird. Die Ebene 8 liegt parallel versetzt zur Mittelebene 7, wobei ihr Abstand zur Rückseite 6 der Halbleiterscheibe höchstens 80% vom Abstand d ist, der zwischen der Mittelebene 7 und der Rückseite 6 der Halbleiterscheibe besteht. Dies ist insbesondere dann von Vorteil, wenn beim Beschichten der Vorderseite der Halbleiterscheibe vermieden werden soll, daß die Halbleiterscheibe durch eine aufwachsende Schicht mit dem Träger verbunden wird.

Nach der in Fig.2 gezeigten Weiterbildung der Erfindung wird der Transport von Abscheidegas zu den Stellen, an denen sich die Halbleiterscheibe und der Träger berühren durch einen Schutzring 9 erschwert. Der Schutzring 9 läuft mit gleichbleibendem Abstand zur Kante 4 um die liegende Halbleiterscheibe herum. Um den Gastransport wirksam einzuschränken, sollte die Höhe h des Schutzrings so gewählt werden, daß sich der Schutzring nach oben hin bis mindestens zur Ebene erstreckt, in der die Vorderseite 5 der Halbleiterscheibe liegt.

In der dargestellten Ausführungsform ist der Schutzring mit dem Träger lösbar verbunden und kann entfernt werden, bevor die Halbleiterscheibe mit einem Greifwerkzeug, das vorzugsweise nur in die Kante der Halbleiterscheibe eingreift, auf den Träger gelegt oder vom Träger gehoben wird. Der Schutzring kann auch so ausgebildet sein (nicht dargestellt), daß er die Kante überdeckt und so eine unerwünschte Beschichtung der Kante verhindert.

Im Fall, daß der Schutzing 9 und der Träger 1 unlösbar verbunden sind, muß gewährleistet sein, daß das Greifwerkzeug die Halbleiterscheibe auf die Erhebungen 3 des Trägers legen kann. Dies kann beispielsweise dadurch geschehen, daß der Ring mit Ausnehmungen (nicht dargestellt) versehen ist, die dem Greifwerkzeug beim Ablegen oder Aufnehmen der Halbleiterscheibe den notwendigen Platz bieten.

In der Darstellung gemäß Fig.la hat der Träger 1 die Form eines Tellers mit einem geschlossenen Boden 10. Der geschlossene Boden verhindert beispielsweise, daß Abscheidegas zur Rückseite 6 der Halbleiterscheibe gelangen kann und die Rückseite mitbeschichtet wird. Im Fall, daß die Rückseite und die Vorderseite der Halbleiterscheibe gleichermaßen behandelt werden sollen, kann im Boden 10 des Trägers eine zentrale Öffnung 11 vorgesehen sein, die dem Träger die Form eines Rings verleiht und in der Fig.1a nur angedeutet ist.

Der beschriebene Träger wird vorzugsweise für Behandlungen von Halbleiterscheiben bei Temperaturen von mindestens 200°C verwendet. Zur Behandlung von Halbleiterscheiben aus Silicium ist der Träger vozugsweise aus Glas, Quarzglas, Keramik oder Silicium gefertigt. Gegebenenfalls ist der Träger zusätzlich mit einer diffusionshemmenden Schicht beschichtet, so daß nahezu ausgeschlossen ist, daß Fremdstoffe vom Untergrund oder vom Träger zur Halbeiterscheibe diffundieren und sie verunreinigen können.

Vor der Behandlung wird die Halbleiterscheibe mit einem Greifwerkzeug auf den Träger gelegt. Der Träger kann sich bereits auf einem Transportband befinden, das ihn zusammen mit der Halbleiterscheibe in die Behandlungsstation transportiert. Es können auch mehrere, mit Halbleiterscheiben beladene Träger in einer Horde übereinander gestapelt werden und die Halbleiterscheiben gemeinsam behandelt werden. In jedem Fall bilden ein Träger und eine Halbleiterscheibe während der Behandlung der Halbleiterscheibe eine Einheit. Es ist daher zweckmäßig, einen benutzten Träger in regelmäßigen Abständen zu reinigen und ihn gegebenenfalls von abgeschiedenen Schichten zu befreien.

## Patentansprüche

1. Einheit aus einer Halbleiterscheibe (2) und einem Träger (1), dadurch gekennzeichnet, daß die Halbleiterscheibe eine ebene Vorderseite (5), eine ebene Rückseite (6) und eine verrundete Kante (4) besitzt und auf dem Träger abgestützt ist, wobei der Träger mindestens drei Erhebungen (3) aufweist, auf denen die verrundete Kante der Halbleiterscheibe abgestützt ist, so daß die Halbleiterscheibe im wesentlichen waagerecht zu liegen kommt, und der Träger die Vorder- und die Rückseite der Halbleiterscheibe nicht berührt, und die Erhebungen so geformt sind, daß die Kante der Halbleiterscheibe ausschließlich unterhalb einer gedachten Mittelebene (7) in der Mitte zwischen der Vorder- und der Rückseite der Halbleiterscheibe abgestützt wird.

2. Einheit nach Anspruch 1, dadurch gekennzeichnet, daß die Erhebungen des Trägers so geformt sind, daß die Kante der Halbleiterscheibe ausschließlich unterhalb einer gedachten Ebene (8) abgestützt wird, die parallel zur Mittelebene versetzt liegt und deren Abstand zur Rückseite der Halbleiterscheibe höchstens 80 % vom Abstand ist, der zwischen der Mittelebene und der Rückseite der Halbleiterscheibe besteht.

3. Einheit nach Anspruch 1 oder Anspruch 2, gekennzeichnet durch einen Schutzring (9) der um die Kante der waagerecht liegenden Halbleiterscheibe mit gleichbleibendem Abstand zur Kante herumgeführt ist.

4. Einheit nach einem der Ansprüche 1 bis 3, dadurch gekennzeichnet, daß der Träger aus einem Material besteht, das aus einer Gruppe ausgewählt ist, die Glas, Quarzglas, Keramik und Silicium umfaßt.

5. Einheit nach einem der Ansprüche 1 bis 4, dadurch gekennzeichnet, daß der Träger mit einer Schutzschicht beschichtet ist, die die Diffusion von Fremdstoffen hemmt.

6. Einheit nach einem der Ansprüche 1 bis 5, dadurch gekennzeichnet, daß der Träger als Ring mit einem zentralen Loch ausgebildet ist, und das Loch einen freien Zugang zur Rückseite der Halbleiterscheibe ermöglicht.

7. Einheit nach einem der Ansprüche 1 bis 5, dadurch gekennzeichnet, daß der Träger als Teller mit geschlossenem Boden ausgebildet ist, und der Boden die Rückseite der Halbleiterscheibe vollständig abdeckt.

8. Verfahren zur Behandlung einer Halbleiterscheibe, dadurch gekennzeichnet, daß eine Einheit gemäß einem der Ansprüche 1 bis 7 Temperaturen von mindestens 200 °C ausgesetzt wird.

## Claims

1. Unit consisting of a semiconductor wafer (2) and a carrier (1), characterized in that the semiconductor wafer has a flat front side (5), a flat rear side (6), and a rounded edge (4) and is supported on the carrier, the carrier having at least three protrusions (3), on which the rounded edge of the semiconductor wafer is supported so that the semiconductor wafer ends up essentially horizontal and the carrier does not make contact with the front side and the rear side of the semiconductor wafer, and the protrusions are shaped so that the edge of the semiconductor wafer is supported exclusively below an imaginary central plane (7) in the centre between the front side and the rear side of the semiconductor wafer.

2. Unit according to Claim 1, characterized in that the protrusions of the carrier are shaped in such a way that the edge of the semiconductor wafer is supported exclusively below an imaginary plane (8), which is in an offset manner parallel to the central plane and whose distance from the rear side of the semiconductor wafer is at most 80% of the distance which exists between the central plane and the rear side of the semiconductor wafer.

3. Unit according to Claim 1 or Claim 2, characterized by a guard ring (9), which is placed around the edge of the horizontally situated semiconductor wafer at constant distance from the edge.

4. Unit according to one of Claims 1 to 3, characterized in that the carrier is composed of a material which is chosen from a group comprising glass, quartz glass, ceramic and silicon.

5. Unit according to one of Claims 1 to 4, characterized in that the carrier is coated with a protective layer which inhibits the diffusion of contaminants.

6. Unit according to one of Claims 1 to 5, characterized in that the carrier is formed as a ring having a central hole and the hole makes possible free access to the rear side of the semiconductor wafer.

7. Unit according to one of Claims 1 to 5, characterized in that the carrier is formed as a plate with continuous base and the base covers the rear side of the semiconductor wafer completely.

8. Method for the treatment of a semiconductor wafer, characterized in that a unit according to one of Claims 1 to 7 is subjected to temperatures of at least 200°C.

## Revendications

1. Unité composée d'une plaque semi-conductrice (2) et d'un support (1), caractérisée en ce que la plaque semi-conductrice possède une face avant plane (5), une face arrière plane (6) et un bord arrondi (4) et est appuyée sur le support, étant entendu que le support présente au moins trois bosses (3) sur lesquelles le bord arrondi de la plaque semi-conductrice est appuyé, de sorte que la plaque semi-conductrice est essentiellement couchée horizontalement et que le support n'est pas en contact avec les faces avant et arrière de la plaque semi-conductrice, et que les bosses sont façonnées de telle sorte que le bord de la plaque semi-conductrice est appuyé exclusivement sous un plan médian imaginaire (7), au centre entre la face avant et la face arrière de la plaque semi-conductrice.

2. Unité suivant la revendication 1, caractérisée en ce que les bosses du support sont façonnées de telle sorte que le bord de la plaque semi-conductrice est appuyé exclusivement sous un plan imaginaire (8) qui est décalé parallèlement par rapport au plan médian et dont la distance par rapport à la face arrière de la plaque semi-conductrice est au maximum égale à 80% de la distance qui existe entre le plan médian et la face arrière de la plaque semi-conductrice.

3. Unité suivant la revendication 1 ou la revendication 2, caractérisée en ce qu'un anneau de garde (9) entoure le bord de la plaque semi-conductrice se présentant à l'horizontale à distance invariable par rapport au bord.

4. Unité suivant l'une des revendications 1 à 3, caractérisée en ce que le support est constitué d'un matériau qui est choisi parmi un groupe qui comprend le verre, le verre quartzeux, la céramique et le silicium.

5. Unité suivant l'une des revendications 1 à 4, caractérisée en ce que le support est recouvert d'une couche de protection qui empêche la diffusion de substances étrangères.

6. Unité suivant l'une des revendications 1 à 5, caractérisée en ce que le support est conçu comme un anneau pourvu d'une ouverture centrale, et en ce que l'ouverture permet un libre accès à la face arrière de la plaque semi-conductrice.

7. Unité suivant l'une des revendications 1 à 5, caractérisée en ce que le support est conçu comme un plateau à fond fermé, et en ce que le fond couvre la face arrière de la plaque semi-conductrice dans sa totalité.

8. Procédé pour le traitement d'une plaque semi-conductrice, caractérisé en ce qu'une unité suivant l'une des revendications 1 à 7 est exposée à des températures d'au moins 200°C.
